Europäisches Patentamt

European Patent Office

Office européen des brevets

(19)

(11) **EP 1 494 035 A1**

(12) **EUROPÄISCHE PATENTANMELDUNG**

(43) Veröffentlichungstag:
**05.01.2005 Patentblatt 2005/01**

(51) Int Cl.$^7$: **G01R 25/00**

(21) Anmeldenummer: 03015205.2

(22) Anmeldetag: **04.07.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(71) Anmelder: **SIEMENS AKTIENGESELLSCHAFT
80333 München (DE)**

(72) Erfinder:
• **Meier, Matthias
92284 Poppenricht (DE)**
• **Prölss, Manfred
92263 Ebermannsdorf (DE)**

(54) **Vorrichtung und Verfahren zur Ermittlung der relativen Phasenverschiebung zwischen Strom und Spannung**

(57) Die Messung der relativen Phase zwischen Strom und Spannung beispielsweise bei der Ansteuerung von Motoren soll vereinfacht werden. Dazu ist vorgesehen, dass aus dem Stromverlauf und dem Spannungsverlauf ein Phasensignal gewonnen wird, das unterschiedliche Vorzeichen der absoluten Phasenlagen des Stromverlaufs und des Spannungsverlaufs, betrachtet von -π bis +π, zueinander wiederspiegelt. Das Phasensignal wird unter Gewinnung eines, die relative Phase zwischen Stromverlauf und Spannungsverlauf repräsentierenden Abtastwerts, abgetastet.

FIG 1

EP 1 494 035 A1

**Beschreibung**

Die vorliegende Erfindung betrifft eine Vorrichtung zur Bestimmung der relativen Phase beziehungsweise Phasenverschiebung zwischen dem Stromverlauf und dem Spannungsverlauf bei Dreh- beziehungsweise Wechselströmen mit einer Stromerfassungseinrichtung zur Erfassung des Stromverlaufs und einer Spannungserfassungseinrichtung zur Erfassung des Spannungsverlaufs. Darüber hinaus betrifft die vorliegende Erfindung ein entsprechendes Verfahren zur Bestimmung der relativen Phase.

Zur Ansteuerung von Motoren ist es häufig notwendig, die Wirkleistung des ansteuerndes Wechselstroms zu kennen. Zur Bestimmung dieser Wirkleistung wird neben dem Strom und der Spannung auch der relative Phasenwinkel Phi benötigt. Die Wirkleistung P ist nämlich definiert als

$$P = U*I*cos\ Phi = u(t)*i(t) = S*cos\ Phi$$

Folglich ist die Scheinleistung definiert als

$$S = U*I$$

Dabei stellen die Werte U und I jeweils die Effektivwerte und u(t) und i(t) jeweils die Momentanwerte der Spannung und des Stroms dar.

Ein bislang bekanntes Verfahren zur Messung der Wirkleistung eines Wechselstroms basiert auf Leistungsmessung. Dabei werden sowohl die Effektivwerte U und I als auch die Momentanwerte u(t) und i(t) der Spannung und des Stroms erfasst und daraus die Wirkleistung P sowie die Scheinleistung S berechnet. Der Phasenwinkel Phi beziehungsweise dessen Cosinus ergibt sich gemäß der Formel:

$$cos\ Phi = P/S$$

Eine weitere bekannte Möglichkeit zur Bestimmung der Phase zwischen Strom und Spannung basiert auf Zeitmessung. Dabei werden die analogen Signale von Strom und Spannung mit einem A/D-Wandler erfasst und die Nulldurchgänge beider Signale registriert. Die Nulldurchgänge dienen zur Interruptsteuerung für die Erfassung der Zeitverschiebung zwischen den Signalen, wobei spezielle Interrupteingänge an dem verwendeten Mikrocontroller erforderlich sind. Zur Bestimmung der relativen Phasenlage ist neben der Messung der Zeit zwischen den Nulldurchgängen auch die Signalfrequenz zu erfassen. Dieses Verfahren ist verhältnismäßig störanfällig, da beispielsweise ein falsch oder nicht registrierter Interrupt für die Zeitmessung die Bestimmung der Phase Phi gänzlich unmöglich macht.

Eine Variante der Bestimmung der Phase Phi mittels Zeitmessung ist in der Druckschrift EP 0 788 210 B1 beschrieben. Dort wird zur Ermittlung der Phase eine Kombination aus digitalen und analogen Signalen verwendet. Speziell wird der Strom analog und die Spannung nach HW-Anpassung digital erfasst. Auch dieses Verfahren ist aufgrund der interruptgesteuerten Zeitmessung störanfällig.

Die Aufgabe der vorliegenden Erfindung besteht somit darin, die Messung der relativen Phase zwischen Strom und Spannung mit einer vereinfachten Vorrichtung und einem vereinfachten Verfahren zu realisieren.

Erfindungsgemäß wird diese Aufgabe gelöst durch eine Vorrichtung zur Bestimmung der relativen Phase zwischen dem Stromverlauf und dem Spannungsverlauf bei Wechselströmen mit einer Stromerfassungseinrichtung zur Erfassung des Stromverlaufs und einer Spannungserfassungseinrichtung zur Erfassung des Spannungsverlaufs, sowie einer Signalerzeugungsschaltung zum Gewinnen eines Phasensignals, das unterschiedliche Vorzeichen der absoluten Phasenlagen, betrachtet von -n bis +n, des Stromverlaufs und des Spannungsverlaufs zueinander wiederspiegelt, und einer Abtasteinrichtung zum Abtasten des Phasensignals unter Gewinnung eines die relative Phase zwischen Stromverlauf und Spannungsverlauf repräsentierenden Abtastwerts.

Darüber hinaus ist erfindungsgemäß vorgesehen ein Verfahren zur Bestimmung der relativen Phase zwischen dem Stromverlauf und dem Spannungsverlauf bei Wechselströmen durch Erfassen des Stromverlaufs und Erfassen des Spannungsverlaufs, sowie Gewinnen eines Phasensignals, das unterschiedliche Vorzeichen der absoluten Phasenlagen, betrachtet von -n bis +n, des Stromverlaufs und des Spannungsverlaufs zueinander wiederspiegelt, und Abtasten des Phasensignals unter Gewinnung eines die relative Phase zwischen Stromverlauf und Spannungsverlauf repräsentierenden Abtastwerts.

Damit ist es möglich, die Phase Phi frequenzunabhängig zu bestimmen, wobei lediglich das Abtasttheorem einzuhalten ist. Weiterhin ist durch die Erfindung eine hohe Störunanfälligkeit gegeben. Einzelne Fehlabtastungen führen nämlich nur zu einer geringen Abweichung des Gesamtergebnisses. Störungen zwischen den Abtastwerten sind kaum relevant. Dies führt zu deutlichen Vorzügen gegenüber Methoden mit Zeitmessung.

Vorzugsweise umfasst die Signalerzeugungsschaltung eine Rechtecksignalerzeugungsschaltung zum Erzeugen jeweils eines Rechtecksignals aus dem Stromverlauf und dem Spannungsverlauf sowie eine Logikschaltung zum x-OR-Verknüpfen der beiden Rechtecksignale, wobei das resultierende Signal dem Phasensignal entspricht. Alternativ kann die Signalerzeugungsschaltung einen Multiplizierer zur Multiplikation des Spannungsverlaufs und des Stromverlaufs besitzen, wobei das resultierende Signal auch hier dem Phasensignal entspricht.

Die erfindungsgemäße Vorrichtung kann ferner eine Recheneinrichtung aufweisen, um aus dem Abtastwert einen Phasenwert und insbesondere den Cosinus davon zu berechnen. Da erfindungsgemäß keine Divisionen und Multiplikationen notwendig sind, braucht die Recheneinrichtung wenig Rechenzeit bei günstiger Wahl der Abtastwerte. Darüber hinaus kann die Prozessorlast gleichmäßig verteilt gestaltet werden, da sie im Wesentlichen durch Abtasten und Inkrementieren bestimmt ist und nicht interrupt-ausgelöst hohe Lastspitzen erzeugt werden.

Die Logikeinrichtung, die Abtasteinrichtung und die Recheneinrichtung können in einen Mikrocontroller integriert werden. Dieser kann ausschließlich auf digitale Eingänge beschränkt werden, falls die genannte Rechtecksignalerzeugungsschaltung dem Mikrocontroller vorgeschaltet ist.

Die vorliegende Erfindung wird nun anhand der beigefügten Zeichnungen näher erläutert, in denen zeigen:

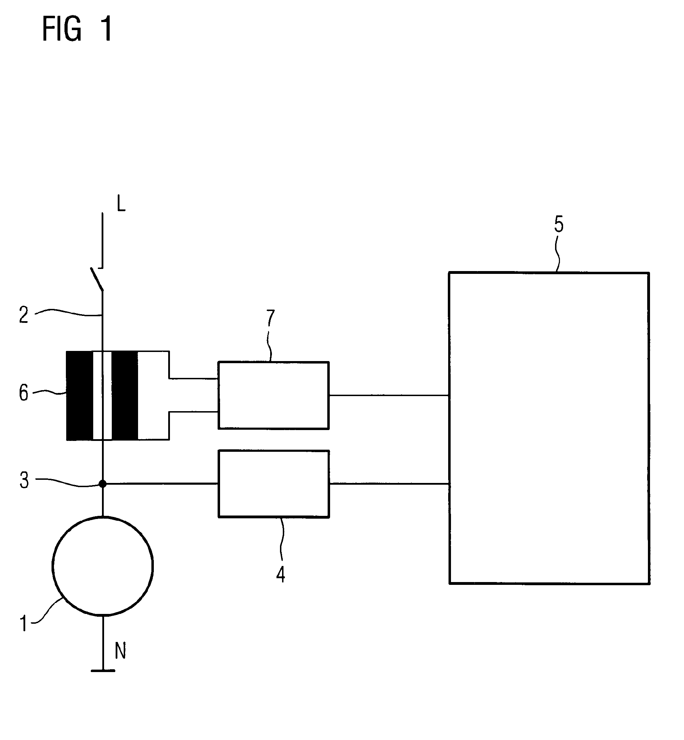

FIG 1    ein Schaltungsdiagramm einer erfindungsgemäßen Vorrichtung zur Bestimmung der relativen Phase zwischen Strom und Spannung;

FIG 2    Signalverlaufsdiagramme eines Strom- und Spannungssignals und dazugehörige Rechtecksignale; und

FIG 3    ein aus den Rechtecksignalen gewonnenes Phasensignal und entsprechendes Abtastsignal.

Die nachfolgend näher beschriebenen Ausführungsformen stellen bevorzugte Ausführungsbeispiele der vorliegenden Erfindung dar.

Ein Motor 1 wird über eine Leitung 2 mit einem Wechselstrom versorgt. An einem Abgreifpunkt 3 wird die Spannung am Motor 1 abgegriffen. Die analoge Wechselspannung wird mittels einer Rechtecksignalerzeugungsschaltung 4 in ein Rechtecksignal gewandelt, das an einen Digitaleingang eines Mikrocontrollers 5 angelegt wird.

Der Strom zur Versorgung des Motors 1 wird mit Hilfe einer Spule 6 induktiv an der Leitung 2 abgegriffen. Eine nachgeschaltete Rechtecksignalerzeugungsschaltung 7 erzeugt auch hier aus dem analogen Stromverlaufsignal ein Rechtecksignal, das dem Mikrocontroller 5 ebenfalls an einem Digitaleingang zur Verfügung gestellt wird.

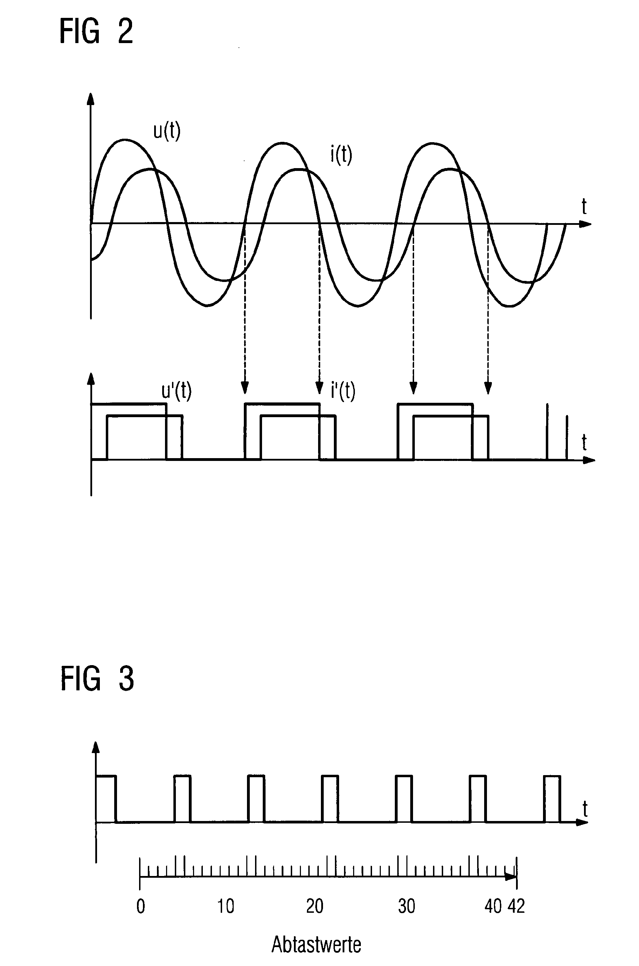

In FIG 2 ist der erfasste Spannungs- und Stromverlauf in dem oben dargestellten Diagramm wiedergegeben. In den Rechtecksignalerzeugungsschaltungen 4 und 7, die beispielsweise durch Komparatoren realisiert werden können, werden Spannung und Strom in symmetrische Rechtecksignale gemäß folgender Vorschrift umgewandelt:

if (u(t) > 0)      u'(t) = 1;
if ( u(t) < 0)      u'(t) = 0;

Daraus resultieren die im unteren Diagramm von FIG 2 dargestellten Rechtecksignale u'(t) und i'(t). Die Phasenverschiebung der Rechtecksignale u'(t) und i'(t) entspricht der der Analogsignale u(t) und i(t).

Die Rechtecksignale u'(t) und i'(t) werden in dem Mikrocontroller 5 einer x-OR-Verknüpfung unterzogen. Daraus resultiert das in FIG 3 oben wiedergegebene Signal. Dieses Signal ist von 0 verschieden, wenn die Analogsignale u(t) und i(t) unterschiedliches Vorzeichen besitzen. Dieses Signal dient zur Phasenbestimmung und wird in diesem Dokument daher als Phasensignal mit jeweiligen Phasenwerten bezeichnet. Das Phasensignal wird in dem Mikrocontroller 5 anschließend abgetastet, wobei das Abtasttheorem eingehalten wird. Die Anzahl der Abtastwerte, die von 0 verschieden sind, wird aufsummiert beziehungsweise inkrementiert und die Summe wird in Relation zu der Gesamtzahl der Abtastwerte gebracht. Aus diesem Verhältnis ergibt sich die relative Verschiebung zwischen dem Spannungsverlauf u(t) und dem Stromverlauf i(t).

An dem folgenden Beispiel sei diese Berechnung näher erläutert:
Die Gesamtzahl der Abtastwerte in einem bestimmten Zeitraum sei n. Die Anzahl der von 0 verschiedenen Abtastwerte, d. h. bei denen das Phasensignal ungleich 0 ist (kurz x-OR-Abtastwerte), sei X. Damit ergibt sich für den Fall X = 0 keine Verschiebung, d. h. Phi = 0°. Demgegenüber ergibt sich für den Fall X = n eine Verschiebung von Phi = 180°. Die Phasenverschiebung Phi lässt sich aus der folgenden allgemeinen Formel herleiten:

$$|Phi| = (X / n) *180°$$

Der Winkel Phi kann nur betragsmäßig ermittelt werden; das Vorzeichen ist jedoch für die Ermittlung des Cosinus Phi nicht relevant, da Cos Phi = cos (-Phi).

Für die Anzeige des Cosinus Phi ist bei Lasten nur ein Cosinus Phi >= 0 relevant, da Werte < 0 eine Generatormaschine anzeigen.

Um sinnvolle Ergebnisse zu erhalten, ist nicht nur das Abtasttheorem einzuhalten, sondern die Gesamtzahl der Abtastwerte n entsprechend groß zu wählen. Wird das Abtasttheorem wissentlich beispielsweise durch Unterabtastung verletzt, ist die Abtastfrequenz so zu wählen, dass keine "Rastung" mit der Signalfrequenz vorliegt.

In einem konkreten Beispiel wäre der Abtastwert n = 42 und der x-OR-Abtastwert X = 10. Folglich ergäbe sich:

$$Phi = (10 / 42) *180°$$

Phi = 42,9°

Dabei ist zu beachten, dass mit steigender Anzahl der Abtastwerte auch die Auflösung des Phasenwinkels entsprechend steigt.

**Patentansprüche**

1. Vorrichtung zur Bestimmung der relativen Phase zwischen dem Stromverlauf und dem Spannungsverlauf bei Wechselströmen mit

   - einer Stromerfassungseinrichtung (6) zur Erfassung des Stromverlaufs und
   - einer Spannungserfassungseinrichtung zur Erfassung des Spannungsverlaufs,

   **gekennzeichnet durch**

   - eine Signalerzeugungsschaltung zum Gewinnen eines Phasensignals, das unterschiedliche Vorzeichen der absoluten Phasenlagen, betrachtet von -n bis +n, des Stromverlaufs und des Spannungsverlaufs zueinander wiederspiegelt, und
   - eine Abtasteinrichtung zum Abtasten des Phasensignals unter Gewinnung eines die relative Phase zwischen Stromverlauf und Spannungsverlauf repräsentierenden Abtastwerts.

2. Vorrichtung nach Anspruch 1, wobei die Signalerzeugungsschaltung eine Rechteckerzeugungsschaltung (4, 7) zum Erzeugen jeweils eines Rechtecksignals aus dem Stromverlauf und dem Spannungsverlauf sowie eine Logikschaltung zum x-OR-Verknüpfen der beiden Rechtecksignale umfasst, wobei das resultierende Signal dem Phasensignal entspricht.

3. Vorrichtung nach Anspruch 1, wobei die Signalerzeugungsschaltung einen Multiplizierer zur Multiplikation des Spannungsverlaufs und des Stromverlaufs umfasst und das resultierende Signal dem Phasensignal entspricht.

4. Vorrichtung nach einem der vorhergehenden Ansprüche, die eine Recheneinrichtung aufweist, um aus dem Abtastwert einen Phasenwert und insbesondere den Cosinus davon zu berechnen.

5. Vorrichtung nach Anspruch 2 und 4, wobei die Logikeinrichtung und die Recheneinrichtung in einen Mikrocontroller (5) integriert sind.

6. Verfahren zur Bestimmung der relativen Phase zwischen dem Stromverlauf und dem Spannungsverlauf bei Wechselströmen durch

   - Erfassen des Stromverlaufs und
   - Erfassen des Spannungsverlaufs,

   **gekennzeichnet durch**

   - Gewinnen eines Phasensignals, das unterschiedliche Vorzeichen der absoluten Phasenlagen, betrachtet von -n bis +n, des Stromverlaufs und des Spannungsverlaufs zueinander wiederspiegelt, und
   - Abtasten des Phasensignals unter Gewinnung eines die relative Phase zwischen Stromverlauf und Spannungsverlauf repräsentierenden Abtastwerts.

7. Verfahren nach Anspruch 6, wobei das Gewinnen eines Phasensignals ein Erzeugen jeweils eines Rechtecksignals aus dem Stromverlauf und dem Spannungsverlauf sowie ein x-OR-Verknüpfen der beiden Rechtecksignale umfasst.

8. Verfahren nach Anspruch 6, wobei das Gewinnen eines Phasensignals ein Multiplizieren des Spannungsverlaufs und des Stromverlaufs umfasst.

9. Verfahren nach einem der Ansprüche 6 bis 8, wobei aus dem Abtastwert ein Phasenwert und insbesondere der Cosinus davon berechnet wird.

10. Verfahren nach Anspruch 7 und 9, wobei das x-OR-Verknüpfen der Rechtecksignale, das Abtasten und das Berechnen des Phasenwerts aus dem Abtastwert in einem Mikrocontroller durchgeführt wird, in dem die Signale ausschließlich digital eingegeben werden.

FIG 1

FIG 2

FIG 3

Abtastwerte

**Europäisches Patentamt**

# EUROPÄISCHER RECHERCHENBERICHT

Nummer der Anmeldung

EP 03 01 5205

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,Y | US 5 777 833 A (ROMILLON JEAN-MARC) 7. Juli 1998 (1998-07-07) * Zusammenfassung; Abbildung 1 * * Spalte 2, Zeile 15 - Zeile 50 * --- | 1-10 | G01R25/00 |
| Y | LUCASSEN R: "DIGITAL PHASE METER" ELEKTOR ELECTRONICS, ELEKTOR PUBLISHERS LTD. CANTERBURY, GB, Bd. 17, Nr. 190, 1. Juni 1991 (1991-06-01), Seiten 32-39, XP000229955 ISSN: 0268-4519 * Zusammenfassung; Abbildungen 1-3 * * Seite 32, Absatz 3 - Seite 33, Spalte 3, Absatz 5 * --- | 1-10 | |
| X | US 4 502 005 A (LISNER HERBERT ET AL) 26. Februar 1985 (1985-02-26) * Zusammenfassung; Abbildungen 2,4,7 * --- | 1,3,4,6, 8,9 | |
| X | US 4 527 080 A (ZWEIG WALTER L) 2. Juli 1985 (1985-07-02) * Zusammenfassung; Abbildungen 1,2 * --- | 1,2,6,7 | **RECHERCHIERTE SACHGEBIETE** (Int.Cl.7) G01R |
| X | PATENT ABSTRACTS OF JAPAN vol. 015, no. 033 (P-1158), 25. Januar 1991 (1991-01-25) -& JP 02 272365 A (OMRON TATEISI ELECTRON CO), 7. November 1990 (1990-11-07) * Zusammenfassung * --- -/-- | 1,6 | |

Der vorliegende Recherchenbericht wurde für alle Patentansprüche erstellt

| Recherchenort | Abschlußdatum der Recherche | Prüfer |
|---|---|---|
| BERLIN | 3. Dezember 2003 | Ernst, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

# EP 1 494 035 A1

**Europäisches Patentamt**

## EUROPÄISCHER RECHERCHENBERICHT

Nummer der Anmeldung

EP 03 01 5205

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | HAUG A: "DIGITALE METHODEN DER PHASENMESSUNG" ELEKTROTECHNISCHE ZEITSCHRIFT, AUSGABE B, VDE VERLAG GMBH. BERLIN, DE, Bd. 25, Nr. 11, 5. Juni 1973 (1973-06-05), Seiten 267-270, XP002020133 * Seite 1, Absatz 1 - Seite 2, Spalte 2, Absatz 3 * * Abbildungen 2-4 * * Abbildungen 1,2 * ----- | 1,6 | |
| | | | **RECHERCHIERTE SACHGEBIETE (Int.Cl.7)** |

Der vorliegende Recherchenbericht wurde für alle Patentansprüche erstellt

| Recherchenort | Abschlußdatum der Recherche | Prüfer |
|---|---|---|
| BERLIN | 3. Dezember 2003 | Ernst, M |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 03 01 5205

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-12-2003

| Im Recherchenbericht angeführtes Patentdokument | | | Datum der Veröffentlichung | Mitglied(er) der Patentfamilie | | Datum der Veröffentlichung |
|---|---|---|---|---|---|---|
| US 5777833 | A | | 07-07-1998 | FR | 2744572 A1 | 08-08-1997 |
| | | | | AU | 714569 B2 | 06-01-2000 |
| | | | | AU | 1241797 A | 07-08-1997 |
| | | | | CN | 1175106 A ,B | 04-03-1998 |
| | | | | DE | 69711251 D1 | 02-05-2002 |
| | | | | DE | 69711251 T2 | 17-10-2002 |
| | | | | EP | 0788210 A1 | 06-08-1997 |
| | | | | ES | 2171847 T3 | 16-09-2002 |
| US 4502005 | A | | 26-02-1985 | DE | 3112326 A1 | 07-10-1982 |
| | | | | AT | 10682 T | 15-12-1984 |
| | | | | EP | 0061603 A2 | 06-10-1982 |
| | | | | JP | 57162983 A | 06-10-1982 |
| US 4527080 | A | | 02-07-1985 | KEINE | | |
| JP 02272365 | A | | 07-11-1990 | KEINE | | |

EPO FORM P0461

Für nähere Einzelheiten zu diesem Anhang : siehe Amtsblatt des Europäischen Patentamts, Nr.12/82